# EUROPEAN PATENT SPECIFICATION

(11) **EP 1 697 936 B1**
(45) Date of publication and mention of the grant of the patent: **09.03.2011**
(21) Application number: 04811930.9
(22) Date of filing: 22.11.2004
(51) Int. Cl.: G11B 7/24, G03F 7/00, G11C 13/04

(54) **NOVEL OPTICAL STORAGE MATERIALS BASED ON NARROWBAND OPTICAL PROPERTIES**
NEUARTIGE OPTISCHE SPEICHERMATERIALIEN AUF DER BASIS VON SCHMALBANDIGEN OPTISCHEN EIGENSCHAFTEN
NOUVELLES MATIERES DE STOCKAGE OPTIQUE BASEES SUR DES CARACTERISTIQUES OPTIQUES DE BANDE ETROITE

(30) Priority: 19.12.2003 US 742461
(43) Date of publication of application: 06.09.2006
(73) Proprietor: GENERAL ELECTRIC COMPANY, Schenectady, NY 12345 (US)
(72) Inventor: LAWRENCE, Brian, Lee, Clifton Park, NY 12065 (US); BODEN, Eugene, Pauling, Scotia, NY 12302 (US); DUBOIS, Marc, Keller, TX 76248 (US); CHAN, Kwok, Pong, Troy, NY 12180 (US); TIAN, Peifang, Niskayuna, NY 12309 (US); LONGLEY, Kathryn, Lynn, Saratoga Springs, NY 12866 (US); FILKINS, Robert, John, Niskayuna, NY 12309 (US); LORRAINE, Peter, William, Niskayuna, NY 12309 (US)
(74) Representative: Szary, Anne Catherine
(86) International application number: PCT/US2004/039298
(87) International publication number: WO 2005/066949

(56) References cited:
- WO-A-01/58856
- US-A- 5 719 690
- PATENT ABSTRACTS OF JAPAN vol. 2000, no. 26, 1 July 2002 (2002-07-01) & JP 2001 265199 A (RIKOGAKU SHINKOKAI), 28 September 2001 (2001-09-28)
- IAIN A. MCCULLOCH: "Novel Photoactive Nonlinear Optical Polymers for Use in Optical Waveguides" MACROMOLECULES, vol. 27, no. 7, 1994, pages 1697-1702, XP002324302 cited in the application
- "New NLO Stilbene derivatives bearing phosphonate ester electron withdrawing groups" TETRAHEDRON LETTERS, vol. 38, no. 35, 1997, pages 6131-6134, XP002324244
- W. E. MOERNER, SCOTT M. SILENCE;: "Polymeric photorefractive materials" CHEM. REV., vol. 94, 1994, pages 127-155, XP002324274
- L. YU, WAI KIN CHAN, ZHONGHUA PENG, ALI GHARAVI: "Multifunctional Polymers exhibiting photorefractive effects" ACC. CHEM RES., vol. 29, 1996, pages 13-21, XP002324275

## Description

The present disclosure relates to the storage of digital data using an optical storage medium. More specifically, the present disclosure relates to holographic storage media having dispersed narrowband optically absorbing materials in a substrate. The narrowband materials undergo a photo-induced change upon exposure to light producing large changes in their refractive indices.

Optical data storage technology has largely evolved on the basis of surface storage phenomena. For example, in one of the most common optical storage formats, the compact disc, or CD, the data is encoded as minute variations in the surface of a recording medium. The data are read using optical means (usually a laser), similar to the way in which data recorded in a magnetic medium are readable with a magnetically-sensitive head, or data recorded in a vinyl medium are readable with a needle. Unlike vinyl recording, however, in optical storage the data are usually stored digitally.

US 5,719,690 discloses a photorefractive article, such as a holographic storage device, comprising an optical chromophore, a charge transport agent and a nonpolymeric organic glass matrix.

CD technology, and the related higher-capacity format digital video disc, or DVD, started out as read-only formats in which the data are stored as metalized, microscopic pits on the surface of a substrate. The read-only format was soon followed by recordable and re-writable systems. Examples include magneto-optic systems, in which the orientation of a magnetic domain changes the direction of rotation of the polarization of a reflected, focused light beam; phase-change systems, in which a medium can be locally crystalline or amorphous, with each state having a different reflectivity; and, dye-polymer systems, in which the reflectivity of a medium is changed by high-power illumination. In all surface-based optical data storage systems, each bit of data occupies a specific physical location in the storage medium. The data density of the optical media is therefore limited by physical constraints on the minimum size of a recording spot.

Recognizing the limitations imposed by surface-based formats, attempts were undertaken to develop multi-layer systems. Such systems increase data density by applying surface-based storage techniques to individual layers that are then combined to create a multiple-layer media. Such techniques require the manufacture of special, heterogeneous, layered recording media, whose complexity quickly increases with the number of layers. Due to these complexities, commercially available multi-layer DVD optical storage media offer no more than two data layers, and come in a prerecorded format. The soon-to-be-released Blu-Ray technology also supports multiple layers, but it is only available as a recordable media due to the difficulties of mastering and replicating the data format.

An alternative approach to the traditional surface-based storage system is volumetric storage technology, in which the full volume of a storage medium is used to increase data capacity. The two most common techniques for volumetric storage are multi-layer and holographic. The multi-layer approach resembles the multiple-layer CD/DVD approach except that the data is written and retrieved using various optical phenomena that are sensitive to focused beams, so that various depths in the medium can be addressed by changing the depth of the focus. This technique eliminates the complexities of fabricating multiple layers and assembling them and, furthermore, removes the limitation on the number of layers, making it solely a function of the focusing capabilities of the optical system.

Holographic storage, on the other hand, stores data throughout the volume of the medium via 3D interference patterns. In the holographic recording process, laser light from two beams, a reference beam and a signal beam containing encoded data, meet within the volume of a photosensitive holographic medium. The interference pattern from the superposition of the two beams results in a change or modulation of the refractive index of the holographic medium. This modulation within the medium serves to record both the intensity and phase information from the signal. The recorded intensity and phase data are then retrieved by exposing the storage medium to the reference beam alone. The reference beam interacts with the stored holographic data and generates a reconstructed signal beam that is proportional to the initial signal beam used to store the holographic image. For information on conventional volume holographic storage, see, for example, U.S. Patent Nos. 4,920,220, 5,450,218, and 5,440,669. In addition, non-destructive readout of volume holographic memories may be accomplished by using different wavelengths in the recording and readout phases. See U.S. Patent No. 5,438,439.

Typically, volume holographic storage is accomplished by having data written on the holographic medium in parallel, on arrays or "pages" containing 1 x 10⁶ or more bits. Each bit is generally stored as a part of the interference pattern that generate the index modulation over the volume of the holographic storage medium in a given spot, therefore it is of no consequence to speak in terms of the spatial "location" of a single bit. Instead, each bit can be thought of as consuming some small portion of the overall index modulation. A storage medium that can support large index changes may consequently store multiple pages within the volume of the holographic medium by angular, wavelength, phase-code or related multiplexing techniques.

The heart of any holographic storage system is the medium. Early holographic storage demonstrations used inorganic photorefractive crystals, such as lithium niobate, in which incident light can create refractive index changes. These index changes are due to the photo-induced creation and subsequent trapping of electrons leading to an induced internal electric field that ultimately modifies the index through the linear electro-optic effect. However, the efficiency of these materials is relatively poor and large crystals are required to observe significant effects. More recent work has led to the development of organic polymers that can sustain large index changes due to optically induced polymerization processes. These materials are referred to as photopolymers, the most common of which is based on cationic ring-opening polymerization (CROP). By using a form of chemical amplification the optical sensitivity and efficiency of these materials has been dramatically improved relative to lithium niobate. However, because the index change is predicated on photopolymerization, the material must start out with a significant fraction of the medium in monomer form, which tends to cause the material to be gel-like in consistency and highly sensitive to environmental conditions. Ultimately, the use of organic materials results in a trade-off sacrificing stability and environmental sensitivity for improved efficiency and optical sensitivity.

In order for volumetric holographic data storage to mature into a viable data storage option, the systems and storage media must be developed so that the operation is relatively simple, inexpensive and robust. Foremost in this effort is the development of a material that is both efficient and sensitive to light as well as stable and relatively insensitive to environmental conditions such as temperature and humidity. Complementary to the material development is a simultaneous effort to optimize the reading and writing systems for a given set of material parameters.

### BRIEF DESCRIPTION OF THE INVENTION

The present invention provides holographic storage media as defined in claim 1, including a substrate having dye materials with optical properties localized to narrow regions of the wavelength spectrum. In one aspect the present invention provides a holographic storage medium comprising an optically transparent substrate; a photochemically active narrowband dye material capable of undergoing a photo-induced change embedded in said optically transparent substrate; and at least one photoproduct of said dye. The photoproduct contained in the optically transparent substrate is patterned within the substrate to provide at least one optically readable datum comprised within said holographic storage medium

In another aspect the present invention relates to a method for producing a holographic storage medium as defined in claim 3. In yet another aspect the present invention relates to a method for storing data in a holographic storage medium, as defined in claim 5.

### BRIEF DESCRIPTION OF THE DRAWINGS

FIG. 1 is a depiction of a digital holographic storage setup for writing data (Fig. 1 (a)) and reading stored data (Fig. 1 (b)).
FIG. 2 is a depiction of a diffraction efficiency setup for writing plane wave holograms (Fig. 2(a)) and measuring diffracted light (Fig. 2(b)).
FIG. 3 is a graph showing the absorption and associated refractive index spectra of a representative dye molecule both before and after exposure to light. The shaded area on the left shows the write wavelength band and the shaded area on the right shows the read wavelength band.
FIG. 4 is a depiction of a holographic plane-wave characterization system utilized to characterize dye-doped polycarbonates of the present disclosure.
FIG. 5 is a graph of measurements of plane-wave holographic recording of a dye-doped polycarbonate prepared in accordance with the present disclosure showing the oscillatory behavior of diffracted' light in the medium.
FIG. 6 is a graph of angle selectivity measurement at 0° in a 1.5 mm thick dye-doped polycarbonate of the present disclosure.
FIG. 7 is a graph of measurements of 130 plane-wave angle-multiplexed holograms in a 1.5-mm thick dye-doped polycarbonate medium produced in accordance with the present disclosure showing a M/# between 1.1 and 1.5
FIG. 8 is a graph of measurements of 150 plane-wave angle-multiplexed holograms in a 1.5-mm thick dye-doped polycarbonate medium produced in accordance with the present disclosure showing a M/# of approximately 2.

### DETAILED DESCRIPTION OF THE INVENTION

The present invention provides optical data storage media for use in holographic data storage and retrieval. These holographic storage media include a substrate and a dye material possessing narrowband optical properties selected and utilized on the basis of several important characteristics including the ability to change the refractive index of the dye material upon exposure to light; the efficiency with which the light creates the change; and the separation between the maximum absorption of the dye and the desired wavelength or wavelengths to be used for storing and/or reading the data. The present disclosure provides a method for storing data by locally changing the refractive index of the dye material in a graded fashion (continuous sinusoidal variations), rather than discrete steps, and ultimately using the induced changes as diffractive optical elements. The dye molecule employed is a photochemically active narrowband dye. A photochemically active narrowband dye may be described as a dye molecule that has an optical absorption resonance characterized by a center wavelength associated with the maximum absorption and a spectral width (full width at half of the maximum, FWHM) of less than 500 nm. In addition, the photochemically active narrowband dye molecule undergoes a light induced chemical reaction when exposed to light with a wavelength within the absorption range. This reaction can be a photodecompostion reaction, such as oxidation, reduction, or bond breaking to form smaller constituents, or a molecular rearrangement, such as a sigmatropic rearrangement, or addition reactions including pericyclic cycloadditions.

The substrate utilized in the holographic storage media of the present disclosure comprises a material having sufficient optical quality, e.g., low scatter, low birefringence, and negligible losses at the wavelengths of interest, to render the data in the holographic storage material readable, and is selected from the group consisting of polycarbonates, polyetherimides, polyvinyl chloride, polyolefins (including, but not limited to, linear and cyclic polyolefins and including polyethylene, chlorinated polyethylene, polypropylene, and the like), polyesters, polyamides, polysulfones (including, but not limited to, hydrogenated polysulfones, and the like), polyphenylene sulfides, polyether ketones, polyether ether ketones, polyimides, polyether sulfones, ABS resins, polystyrenes (including, but not limited to, hydrogenated polystyrenes, syndiotactic and atactic polystyrenes, polycyclohexyl ethylene, styrene-co-acrylonitrile, styrene-co-maleic anhydride, and the like), polybutadienes, polyacrylonitrile, polyacetals, polyphenylene ethers (including, but not limited to, those derived from 2,6-dimethylphenol and copolymers with 2,3,6-trimethylphenol, and the like), ethylene-vinyl acetate copolymers, polyvinyl acetate, liquid crystal polymers, ethylene-tetrafluoroethylene copolymer, aromatic polyesters, polyvinyl fluoride, polyvinylidene fluoride, polyvinylidene chloride, and tetrafluoroethylenes.

In some embodiments the plastic utilized in the present disclosure as a substrate is made of a polycarbonate. The polycarbonate may be an aromatic polycarbonate, an aliphatic polycarbonate, or a polycarbonate comprising both aromatic and aliphatic structural units. As used herein, the terms "polycarbonate", "polycarbonate composition", and "composition comprising aromatic carbonate chain units" includes compositions having structural units of the formula (I).

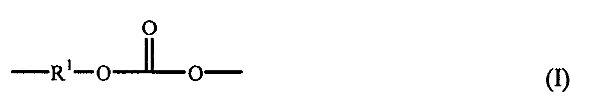

Preferably, R¹ is an aromatic organic radical and, more preferably, a radical of the formula (II):

-A¹-Y¹-A²- (II)

wherein each of A¹ and A² is a monocyclic divalent aryl radical and Y¹ is a bridging radical having zero, one, or two atoms which separate A¹ from A². In an exemplary embodiment, one atom separates A¹ from A². Illustrative, non-limiting examples of radicals of this type are --O--, --S--, --S(O)--, --S(O) ₂--, --C(O)--, methylene, cyclohexyl-methylene, 2-ethylidene, isopropylidene, neopentylidene, cyclohexylidene, cyclopentadecylidene, cyclododecylidene, adamantylidene, and the like. In another embodiment, zero atoms separate A¹ from A², with an illustrative example being biphenol (OH-benzene-benzene-OH). The bridging radical Y¹ can be a hydrocarbon group or a saturated hydrocarbon group such as methylene, cyclohexylidene or isopropylidene, or aryl bridging groups.

Polycarbonates can be produced by the reaction of dihydroxy compounds in which only one atom separates A¹ and A². As used herein, the term "dihydroxy compound" includes, for example, bisphenol compounds having general formula (III) as follows: 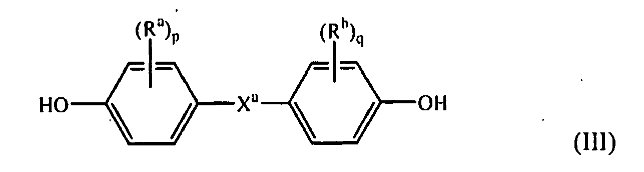 wherein R^{a} and R^{b} each independently represent a halogen atom, or a monovalent hydrocarbon group; p and q are each independently integers from 0 a to 4; and X^{a} represents one of the groups of formula (IV): 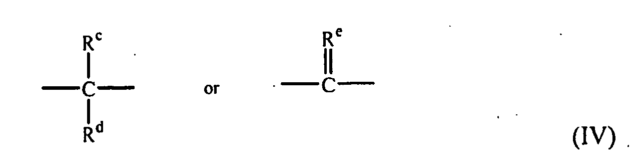 wherein R^{c} and R^{d} each independently represent a hydrogen atom or a monovalent linear or cyclic hydrocarbon group, and R^{e} is a divalent hydrocarbon group. Some illustrative, non-limiting examples of suitable dihydroxy compounds include dihydric phenols and the dihydroxy-substituted aromatic hydrocarbons such as those disclosed by name or formula (generic or specific) in U.S. Patent No. 4,217,438. A nonexclusive list of specific examples of the types of bisphenol compounds that may be represented by formula (III) includes the following: 1,1-bis(4-hydroxyphenyl) methane; 1,1-bis(4-hydroxyphenyl) ethane; 2,2-bis(4-hydroxyphenyl) propane (hereinafter "bisphenol A" or "BPA"); 2,2-bis(4-hydroxyphenyl) butane; 2,2-bis(4-hydroxyphenyl) octane; 1,1-bis(4-hydroxyphenyl) propane; 1,1-bis(4-hydroxyphenyl) n-butane; bis(4-hydroxyphenyl) phenylmethane; 2,2-bis(4-hydroxy-3-methylphenyl) propane (hereinafter "DMBPA"); 1,1-bis(4-hydroxy-t-butylphenyl) propane; bis(hydroxyaryl) alkanes such as 2,2-bis(4-hydroxy-3-bromophenyl) propane; 1,1-bis(4-hydroxyphenyl) cyclopentane; 9,9'-bis(4-hydroxyphenyl) fluorene; 9,9'-bis(4-hydroxy-3-methylphenyl) fluorene; 4,4'-biphenol; and bis(hydroxyaryl) cycloalkanes such as 1,1-bis(4-hydroxyphenyl) cyclohexane and 1,1-bis(4-hydroxy-3-methylphenyl)cyclohexane (hereinafter "DMBPC" or "BCC"); and the like as well as combinations comprising at least one of the foregoing bisphenol compound.

In another embodiment, X^{a} in formula (III) above can be a C₆-C₂₀ aromatic radical. In some embodiments, the aromatic radical can be substituted with groups including, but not limited to, alkyl, aryl, esters, ketones, halides, ethers, and combinations thereof.

It is also possible to employ polycarbonates resulting from the polymerization of two or more different dihydric phenols or a copolymer of a dihydric phenol with a glycol, a hydroxy- or acid-terminated polyester, a dibasic acid, a hydroxy acid, or an aliphatic diacid in the event a carbonate copolymer rather than a homopolymer is desired for use. Generally, useful aliphatic diacids have about 2 to about 40 carbons. A preferred aliphatic diacid is dodecandioic acid. Polyarylates and polyester-carbonate resins or their blends can also be employed.

Branched polycarbonates are also useful, as well as blends of linear polycarbonates and branched polycarbonates. The branched polycarbonates may be prepared by adding a branching agent during polymerization. These branching agents are well known and may comprise polyfunctional organic compounds containing at least three functional groups which may be hydroxyl, carboxyl, carboxylic anhydride, haloformyl, and mixtures comprising at least one of the foregoing branching agents. Specific examples include trimellitic acid, trimellitic anhydride, trimellitic trichloride, tris-p-hydroxy phenyl ethane, isatin-bisphenol, (1,3,5-tris((p-hydroxyphenyl)isopropyl)benzene), (4(4(1,1-bis(p-hydroxyphenyl)-ethyl)α,α(dimethyl benzyl) phenol), 4-chloroformyl phthalic anhydride, trimesic acid, benzophenone tetracarboxylic acid, and the like, as well as combinations comprising at least one of the foregoing branching agents. The branching agents may be added at a level of about 0.05 to about 2.0 weight percent, based upon the total weight of the substrate. Examples of branching agents and procedures for making branched polycarbonates are described in U.S. Patent Nos. 3,635,895 and 4,001,184. All types of polycarbonate end groups are herein contemplated.

Preferred polycarbonates are based on bisphenol A, in which each of A¹ and A² is p-phenylene and Y¹ is isopropylidene. Preferably, the weight average molecular weight of the polycarbonate is about 5,000 to about 100,000 atomic mass units, more preferably about 10,000 to about 65,000 atomic mass units, and most preferably about 15,000 to about 35,000 atomic mass units.

As noted above, the polycarbonate material possesses a dye material. The polycarbonate composition may also include various additives ordinarily incorporated in resin compositions of this type. Such additives are, for example, heat stabilizers; antioxidants; light stabilizers; plasticizers; antistatic agents; mold releasing agents; additional resins; blowing agents; and the like, as well as combinations of the foregoing additives.

One example of a suitable polycarbonate is Lexan®, commercially available from General Electric Company.

In other embodiments a polyetherimide may be used as the substrate. Such materials are known to those skilled in the art and include, for example, Ultem®, an amorphous thermoplastic polyetherimide commercially available from General Electric Company.

Data storage media can be produced by first forming the substrate material using a conventional reaction vessel capable of adequately mixing various precursors, such as a single or twin screw extruder, kneader, blender, or the like.

The extruder should be maintained at a sufficiently high temperature to melt the substrate material precursors without causing decomposition thereof. For polycarbonate, for example, temperatures of about 220° C. to about 360° C. can be used, with about 260° C. to about 320° C. preferred. Similarly, the residence time in the extruder should be controlled to minimize decomposition. Residence times of up to about 2 minutes (min) or more can be employed, with up to about 1.5 min preferred, and up to about 1 min especially preferred. Prior to extrusion into the desired form (typically pellets, sheet, web, or the like, the mixture can optionally be filtered, such as by melt filtering and/or the use of a screen pack, or the like, to remove undesirable contaminants or decomposition products.

Once the plastic composition has been produced, it can be formed into the substrate using various molding and/or processing techniques. Possible techniques include, injection molding, film casting, extrusion, press molding, blow molding, stamping, and the like. Typically the substrate has a thickness of anywhere from under 100 microns to several centimeters or more, depending on the desired optical properties.

As noted above, the holographic storage media of the present disclosure possess a material interspersed throughout that functions as a data storage material. Preferably, this data storage material is a dye possessing narrowband optical properties, i.e., narrowband absorption resonances. In addition, these dyes undergo photo-induced reactions that significantly alter their absorption characteristics. Thus, the dye materials utilized in accordance with the present disclosure allow for increased refractive index changes due to the refractive index dispersion associated with the photo-induced changes in the narrowband absorption resonances.

The photochemically active narrowband dye materials utilized in the present disclosure are preferably organic dyes which undergo an irreversible chemical change upon exposure to certain "write" wavelengths of light which eliminates the absorption band exhibited by the narrowband dye. The photoproduct or photoproducts which result from interaction of the photochemically active narrowband dye with light having the "write" wavelength typically exhibits an absorption spectrum (spectra) which is entirely different from that exhibited by the dye prior to irradiation.. The irreversible chemical change in the dye produced by interaction with light of the write wavelength produces a corresponding change in the molecular structure of the dye, thereby producing a "photoproduct" which may be a cleavage-type photoproduct or a rearrangement type photoproduct. This modification to the structure of the dye molecule and concurrent changes in the light absorption properties of the photoproduct (s) relative to the starting narrowband dye produces a significant change in refractive index within the substrate that can be observed at a separate "read" wavelength. The narrowband dye materials utilized according to the present disclosure also tend to have strong optical characteristics due to conservation of oscillator strength, i.e., because the absorption is localized to a narrow spectral region, the magnitude of the absorption is stronger as the area under the curve (the oscillator strength) is conserved.

As noted, the present disclosure uses narrowband dye materials that undergo a photo-induced change, including a photo-decomposition (such as oxidation or bleaching) or a photo-induced molecular rearrangement. The narrowband materials have the ability to support a linear response to the intensity of the light, as opposed to an on/off response. In the case of photo-decomposition, the material responsible for the narrowband absorption decomposes in the presence of light. As a consequence, the strong absorption resonance of the material disappears, as does the associated refractive index dispersion. The result is a permanent, photo-induced change. For molecular rearrangement, the result is nearly identical but instead of decomposing, the molecules are rearranged resulting in a shift of the absorption to longer or shorter wavelengths. Because these processes use dye materials with strong narrowband absorption, there are strong associated refractive index changes that are modified simultaneously with the absorption.

In an alternative embodiment, the narrowband material can undergo a photo-induced change such as physical transport, wherein the dye material is attached to another molecule which undergoes spatial diffusion in the presence of light. In such a case, larger concentrations of the narrowband materials may aggregate in regions of higher light intensity.

The dye materials can be used in a substrate as described above, such as a polycarbonate or a polyetherimide. The narrowband materials undergo large refractive index changes. These narrowband materials can support wavelength multiplexed optical data storage, for increased data density.

The narrowband dye materials utilized in the present disclosure are suitable for use in a guest-host system wherein the narrowband dye material is the guest and the substrate is the host. In some embodiments, the narrowband dye materials are dissolved with a polymer host in a solvent to produce a solution. Films can be made by spin-coating from this solution. In other embodiments, films can be formed by blade coating, substrate dipping, and spraying. Suitable polymeric substrate materials containing a narrowband dye material are at times referred to as "doped polymers". Such doped polymers can be prepared by a variety of techniques such as the solvent casting technique referred to above. In one embodiment the doped polymers can also be formed by dissolving the narrowband dye material in a liquid monomer and therafter thermally or photoreactively polymerizing the monomer in the presence of ths dye to produce an optically transparent substrate material having dispersed uniformly within it the photochemically active narrowband dye.

In other embodiments, the narrowband dye material of the present disclosure can be chemically bound to a polymer support. Attachment of the dye to the polymer support may be accomplished by including reactive substituents on the dye molecule that participate in a polymerization, reaction. Suitable substituents include simple alcohols, amines, carboxylates, and other reactive functional groups, for example chloroformates. The product polymers comprise the dye which is appended to the polymer. The dye may be incorporated into the backbone of the polymer chain, or attached to the polymer chain as a chain stopper. Suitable polymers include, for example, bisphenol A polycarbonate, polyetherimides, polysulfones and polyamides. Where utilized, films and discs can be formed using methods described above for guest-host systems.

The dye material interspersed throughout the substrate comprises an organic dye having at least two aromatic rings joined by a bridging double bond. Such materials are known to those skilled in the art and include stilbene, stilbene derivatives (including extended stilbenes), azo, and other dye molecules, such as organic nonlinear optical (NLO) materials It has surprisingly been found that dye molecules of the present disclosure having at least one nitro group ortho to the bridging double bond joining at least two aromatic rings are especially well-suited as photo-modifiable dye materials. The aromatic ring of the dye molecule having the o-nitro group may also contain other electron withdrawing groups, typically cyano or additional nitro groups.

In addition, the other aromatic ring of the dye material preferably contains electron donating groups such as primary, secondary, or tertiary amines, preferably tertiary amines; aryloxy groups; alkoxy groups; hydroxyl groups; or inorganic or organic phenoxide salts. In some embodiments, multiple electron donating substituents such as combinations of these groups may also be present on the ring.

Although aldehydes and ketones can also act as electron acceptors and simple alkyl groups as donators, these groups generally have less of an effect and could probably be on either ring without significant changes. Other sulfur and nitrogen compounds could be included as either acceptors or donators depending on the structure of the substituent and whether the group had a net donating or withdrawing effect.

Preferably, the organic dye utilized in accordance with the present disclosure is a nitrostilbene or a nitrostilbene derivative. As noted above, one of the aromatic rings of the nitrostilbene dye molecule has a nitro group ortho to the bridging double bond. Suitable nitrostilbene derivatives include 4-dimethylamino-2',4'- dinitrostilbene, 4-dimethylamino-4'-cyano-2'-nitrostilbene, 4-hydroxy-2',4'- dinitrostilbene, and 4-methoxy-2',4'-dinitrostilbene. These dyes have been synthesized and optically induced rearrangements of such dyes have been studied in the context of the chemistry of the reactants and products as well as their activation energy and entropy factors. J. S. Splitter and M. Calvin, "The Photochemical Behavior of Some o-Nitrostilbenes," J. Org. Chem., vol. 20, pg. 1086 (1955). More recent work has focused on using the refractive index modulation that arises from these optically induced changes to write waveguides into polymers doped with the dyes. McCulloch, 1. A., "Novel Photoactive Nonlinear Optical Polymers for Use in Optical Waveguides," Macromolecules, vol. 27, pg. 1697 (1994).

Additional functional groups which may be substituted on a nitrostilbene derivative include alkyl groups having 1 to 6 carbon atoms such as methyl, ethyl, n-propyl, isopropyl, n-butyl, isobutyl, s-butyl, t-butyl, pentyl, isopentyl, neopentyl, hexyl and the like; those having 1 to 4 carbon atoms such as methyl, ethyl, n-propyl, isopropyl, n-butyl, isobutyl, s-butyl, t-butyl and the like are particularly preferred. Alkoxy groups, aryl groups and aralkyl groups may also be substituted on the nitrostilbene for use in accordance with the present disclosure.

Where utilized, the alkyl group can include a hydroxyalkyl group, alkoxyalkyl group, alkylaminoalkyl group, dialkylaminoalkyl group, alkoxycarbonylalkyl group, carboxyalkyl group, halogenated alkyl group, alkanoyloxyalkyl group, aminoalkyl group and the like.

In some embodiments the alkyl groups preferably have conjugate substituents of electron donating groups such as alkoxy group, alkylamino group, dialkylamino group, amino group and the like.

Examples of the hydroxyalkyl group include those having 1 to 6 carbon atoms in the alkyl moiety such as hydroxymethyl, 2-hydroxyethyl, 1,1-dimethyl-2-hydroxyethyl, 3-hydroxypropyl, 4-hydroxybutyl, 2-hydroxybutyl, 1-hydroxypentyl, 6-hydroxyhexyl and the like.

Examples of the alkoxyalkyl group include those having 1 to 6 carbon atoms in both the alkyl moiety and the alkoxy moiety such as methoxymethyl, methoxyethyl, methoxybutyl, ethoxyhexyl, ethoxymethyl, butoxyethyl, t-butoxyhexyl, hexyloxymethyl and the like.

Examples of the alkylaminoalkyl group include those having 1 to 6 carbon atoms in the alkyl moiety such as methylaminomethyl, ethylaminomethyl, hexylaminomethyl, ethylaminoethyl, hexylaminoethyl, methylaminopropyl, butylaminopropyl, methylaminobutyl, ethylaminobutyl, hexylaminobutyl, methylaminohexyl, ethylaminohexyl, butylaminohexyl, hexylaminohexyl and the like. Substituted alkylamino groups such as hydroxyethylamino fall within the meaning of "alkylamino" as defined herein. Moreover, the hydroxyethylamino group may serve as a useful substituent on the narrowband dye in instances in which the narrowband dye is to be chemically bound to the polymer comprising the optically transparent substrate, as in the case of polymer-bound dyes.

Examples of the dialkylaminoalkyl group include those having 1 to 6 carbon atoms in the alkyl moiety such as dimethylaminomethyl, diethytlaminomethyl, dihexylaminomethyl, diethylaminoethyl, dihexylaminoethyl, dimethylaminopropyl, dibutylaminopropyl, dimethylaminobutyl, diethylaminobutyl, dihexylaminobutyl, dimethylaminohexyl, diethylaminohexyl, dibutylaminohexyl, dihexylaminohexyl and the like.

Examples of the alkoxycarbonylalkyl group include those having 1 to 6 carbon atoms in both the alkyl moiety and alkoxy moiety such as methoxycarbonylmethyl, methoxycarbonylethyl, methoxycarbonylhexyl, ethoxycarbonylmethyl, ethoxycarbonylethyl, propoxycarbonylmethyl, isopropoxycarbonylmethyl, buthoxycarbonylmethyl, pentyloxycarbonylmethyl, hexycarbonylmethyl, hexylcarbonylbutyl, hexylcarbylhexyl and the like.

Examples of carboxyalkyl group include those having 1 to 6 carbon atoms in the alkyl moiety such as carboxymethyl, carboxyethyl, carboxybutyl, carboxyhexyl, 1-methyl-2-carboxyethyl and the like.

Examples of the halogenated alkyl group include alkyl groups having 1 to 6 carbon atoms which are substituted by 1 to 3 halogen atoms such as monochloromethyl, monobromomethyl, monoiodomethyl, monofluoromethyl, dichloromethyl, dibromomethyl, diiodomethyl, difluoromethyl, trichloromethyl, tribromomethyl, triiodomethyl, trifluoromethyl, monochloroethyl, monobromoethyl, monoiodoethyl, monofluoroethyl, dibromobutyl, diiodobutyl, difluorobutyl, chlorohexyl, bromohexyl, iodohexyl, and fluorohexyl. Suitable halogenated alkyl groups also include aryl halides.

Examples of alkanoyloxyalkyl group include alkanoyloxy groups having 2 to 6 carbon atoms in the alkanoyl moiety and 1 to 6 carbon atoms in the alkyl moiety such as acetoxymethyl, 2-acetoxyethyl, propionyloxymethyl, 1-hexanoyloxy-2-methylpentyl and the like.

Examples of alkoxy groups include those having 1 to 6 carbon atoms such as methoxy, ethoxy, propoxy, isopropoxy, butoxy, t-butoxyl, pentyloxyl, hexyloxy and the like. Further, these alkoxy groups are optionally substituted by halogen atom, amino group, hydroxyl group, carboxyl group, alkanoyloxy group and the like, as mentioned above as a substituent for alkyl group.

Examples of aryl groups include groups such as phenyl, naphthyl, anthryl and phenanthryl,

Examples of arylalkyl groups include those having 1 to 6 carbon atoms in the alkyl moiety such as benzyl-1-phenylethyl, 3-phenylpropyl, 4-phenylbutyl, 5-phenylpentyl, and 6-phenylhexyl.

The aryl group and aralkyl group optionally have substituents, examples of which include halogen atom, amino group, hydroxyl group, carboxyl group which are optionally esterified, cyano group and the like in addition to the above-mentioned alkyl groups having 1 to 6 carbon atoms and alkoxy groups having 1 to 6 carbon atoms. Further, substitution positions of these substituents are not necessarily specified.

The size and shape of the holographic storage media of the present disclosure can vary, and can be circular, oval, rectangular, or square in shape. Most preferably the holographic storage media is in the form of a circular disc. The thickness of the holographic storage media can vary, ranging from less than 50 microns to 5 cm or more, more preferably from 0.25 mm to 3 mm, with a thickness of 1 mm to 2 mm being most preferred.

Once formed, the holographic storage media of the present disclosure may be subjected to processes known to those skilled in the art for holographic data storage. Holographic data storage is one of several techniques that attempt to use the full volume of a storage material to maximize data density (as opposed to surface storage as is used in CD and DVD style systems). In the holographic storage process, the data is used to generate an optical interference pattern, which is subsequently stored in the holographic storage media of the present disclosure.

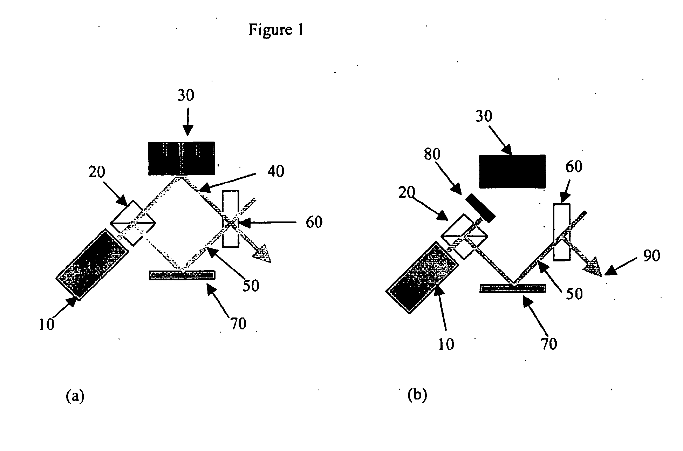

An example of a suitable holographic data storage process to create holographic storage media of the present disclosure is set forth in Figure 1a. In this configuration the output from a laser 10 (532 nm) is divided into two equal beams by beam splitter 20. One beam, the signal beam 40, is incident on some form of spatial light modulator (SLM) or deformable mirror device (DMD) 30, which imposes the data to be stored on the signal beam 40. This device is composed of a number of pixels that can block or transmit the light based upon input electrical signals. Each pixel can represent a bit or a part of a bit (a single bit may consume more than one pixel of the SLM or DMD) of data to be stored. The output of the SLM or DMD 30 is then incident on the storage material 60. The second beam, the reference beam 50, is transmitted all the way to the storage material 60 by reflection off mirror 70 with minimal distortion. The two beams are coincident on the same area of the storage material 60 at different angles. The net result is that the two beams create an interference pattern at their intersection in the material. The interference pattern is a unique function of the data imparted to the signal beam 40 by the SLM or DMD 30. The dye material within the homographic storage media undergoes a chemical change that results in a modification of the refractive index in the region exposed to the laser light, and consequently the interference pattern that is created is "fixed" into the holographic storage media, effectively creating a grating in the storage material 60.

For reading the data, as depicted in Figure 1b, the grating or pattern created in the storage material 60 is simply exposed to the reference beam 50 in the absence of the signal beam by blocking same with a shutter 80 and the data is reconstructed in a recreated signal beam 90.

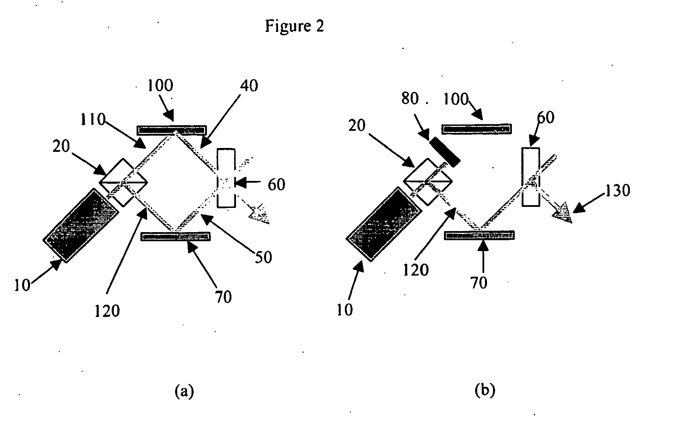

In order to test the characteristics of the material, a diffraction efficiency measurement can be used. A suitable system for these measurements is shown in Figure 2a. This setup is very similar to the holographic storage setup; however, there is no SLM or DMD, but instead, a second mirror 100. The laser 10 (532 nm) is split into two beams 110 and 120 that are then interfered in the storage material 60 creating a plane wave grating. As depicted in Figure 2b, one of the beams is then turned off or blocked with shutter 80 and the amount of light diffracted by the grating in storage material 60 is measured. The diffraction efficiency is measured as the power in the diffracted beam 130 versus the amount of total power incident on the storage material. More accurate measurements may also take into account losses in the material due to reflections at the surfaces and absorption in the volume

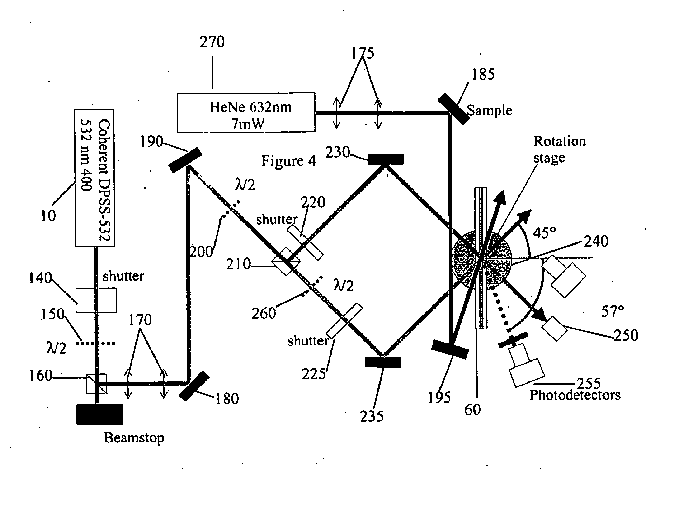

Alternatively, a holographic plane-wave characterization system may be used to test the characteristics of the material, especially multiplexed holograms. Such a system can provide the M/# for a given sample, which is the metric used to characterize the ultimate dynamic range or information storage capacity of the sample as measured by the maximum number and efficiency of multiplexed holograms stored in the material. A suitable system for these measurements is shown in Figure 4. In this setup the output from laser 10 (Coherent, Inc DPSS 532) is passed through shutter 140 for read/write control, and then through a combination of a half-wave plate, 150, and polarizing beam-splitter, 160, for power control. The light is then passed through a two-lens telescope, 170 (the two double-ended arrows) to adjust the beam size, reflected off mirror 180, and then mirror 190 to transport the beam into the measurement area. The light is then passed through a second half-wave plate, 200, and a second polarizing beam splitter, 210, to split the beam in two and to control the power in each of the two beams. The beam reflected off of the beamsplitter is then passed through a second shutter, 220, which enable independent on/off control of the power in the first beam. The first beam is then reflected off of a mirror; 230, and is incident on the sample, 60 mounted on a rotation stage 240. The light from the first beam transmitted through the sample is collected into detector 250. The second beam is passed through a third half wave plate, 260, to rotate its polarization into the same direction as the first beam and then through shutter 225 to provide on/off control of the second beam. The second beam is then reflected off of mirror 235 and is incident on the sample. For measuring the *in situ* dynamic change in the sample during exposure, a second laser, 270, is passed through a two-lens telescope, 175, reflected of mirror 185 and mirror 195 and is then coincident on the sample at the same locations as the first and second beams. The diffracted beam is then collected into detector 255.

Preferably, the holographic storage media of the present disclosure are utilized in conjunction with a process whereby light of one wavelength from a laser is utilized to write the data into the holographic storage media, while light of a different wavelength is utilized to read the data from the holographic storage media. For the holographic storage media of the present disclosure, the refractive index change is created by using a laser wavelength that is strongly absorbed by the dye. The absorption of this light induces a photochemical reaction that irreversibly converts the dye molecules from one compound to a second compound or set of compounds. The product of the reaction does not have the strong absorption at the laser wavelength that characterized the initial dye. However, because the interference pattern is composed of bright and dark regions, some of the dye is unexposed and needs to remain unexposed to maintain successful operation. The reading wavelength is chosen so that it still falls within the spectral region where the refractive index change is present, but outside the region of strong absorption.

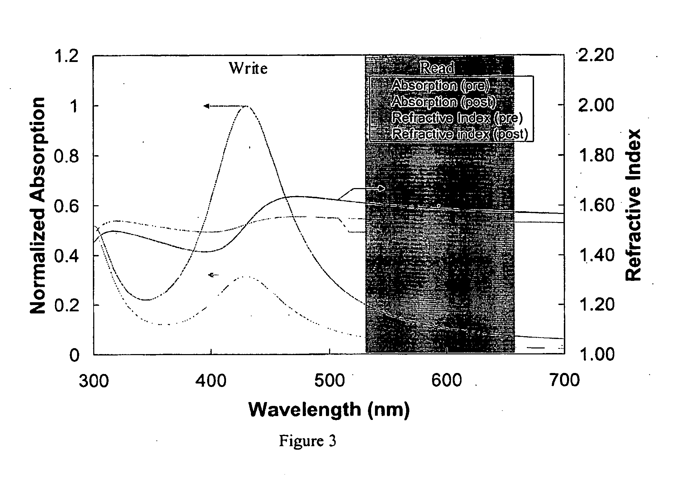

Due to the correlation between the absorption resonance and refractive index, the elimination of the absorption resonance also has a dramatic effect on the refractive index for nearby wavelengths. This relationship is shown graphically in Figure 3, which has been calculated based on an accepted theoretical model (See for example, the electron-oscillator model in "Lasers", P.W. Milonni and J.H. Eberly, New York, NY: John Wiley & Sons, Inc., 1988, and the Karmers-Kronig relationships in "Quantum Electronics 3rd ed., A. Yariv, New York, NY: Wiley Text Books, Inc., 1989). Spectral regions where the refractive index change is present, but outside the region of strong absorption, are also indicated in Figure 3. Details of the read/write process for two-color holography are included in the examples below.

In constructing the holographic storage media of the present disclosure, one can select a dye material and a wavelength of light that would result in a desired absorption at the wavelength of light being used. In some embodiments, the write wavelength band can be any part of the spectrum where more than 10% of the incident light is absorbed. However, having too strong an absorption can cause nonlinearities in the storage of the data leading to poor reconstruction of the stored information. In addition, while reducing the absorption can be accomplished by lowering the concentration of dye material in the substrate, this has the disadvantage of reducing maximum achievable refractive index change and subsequently reducing the efficiency of the material in storing the data. Furthermore, having too little absorption results in a lack of sensitivity and the material requires long exposure times to store data.

An alternative to enhance data storage efficiency is to alter the system so that the wavelength for writing does not coincide with the maximum absorption of the dye material. This allows one to add substantially more dye into the holographic storage medium but still maintain a manageable absorption coefficient such that the data is accurately stored. The proper amount can be determined as a function of the maximum absorption of the dye. For example, if the peak absorption is such that only 1% of the light at the same wavelength is a transmitted, the write wavelength can be chosen away from the peak such that the material transmits from 25% to 75% of the incident light. In some cases, the transmission can range from 40% to 60%, with a transmission of 50% present in some other embodiments.

As one skilled in the art will appreciate, different molecules will have widely differing absorption profiles (broader, narrower, etc.). Thus, the wavelengths utilized for writing and reading the holographic storage media of the present disclosure will depend upon the light source, the substrate, and the dye material. Wavelengths suitable for writing data into the holographic storage media can vary depending upon both the substrate and dye material used, and can range from 375 nm to 550 nm, preferably from 400 nm to 500 nm.

Reading wavelengths are preferably differentiated from the write wavelength such that at the wavelength selected for reading the information contained in the holographic storage medium there is very little or no absorption of the reading light. Preferably the wavelength of light employed for reading is selected such that the difference between the reading wavelength and the absorption band associated with the writing event is maximized. In one embodiment the read beam has a wavelength shifted from 50 nm to 400 nm from the signal beam's wavelength. In some embodiments, a suitable read beam has a wavelength from 400 nm to 800 nm. However, the farther away from the absorption band, the smaller the refractive index change, which negatively impacts the efficiency of the storage process. In addition, the greater the separation between the writing and reading wavelengths the more difficult it may be to reconstruct the data. Thus, reading wavelengths are most preferably selected as the nearest wavelength where the transmission is greater than 95%.

In some embodiments, blue light at wavelengths ranging from 375 nm to 425 nm may be used for writing and green/red light at wavelengths ranging from 500 nm to 800 nm may be used for reading. In other embodiments, the wavelength of light used for writing can range from 425 nm to 550 nm, and the reading wavelength can range from 600 nm to 700 nm. In one embodiment, a wavelength of 532 nm light can be used for writing and wavelengths of either 633 nm or 650 nm light can be used for reading.

The holographic storage media of the present disclosure are able to support a large number of multiplexed holograms which, in some cases, can be driven by the total refractive index contrast between substrates having the dye material and substrates lacking the dye material. The total refractive index contrast, in turn, may in some embodiments be higher in the dye-doped materials of the present disclosure. In other embodiments, the storage material of the present disclosure can be used in a solid format.

The present disclosure is illustrated by the following non-limiting examples.

### EXAMPLES

The test samples comprising the transparent substrate and the photochemically active narrowband dye prepared and tested below in examples 1-3 were based on a polycarbonate host with various amounts of known dyes dissolved in the polycarbonate. The polycarbonate substrate is conveniently referred to as the "host" and the dissolved dye as the "guest dopant". The test samples employed herein as guest dopants stilbene derivatives which were prepared using known synthetic methodology.

All of the films disclosed in the examples below were prepared by dissolving the dye material and substrate, i.e., polycarbonate, in methylene chloride at ∼5 wt% solids and pouring the solution intro cylinder cut from glass tubing (2 inches in diameter and 2 inches in length) resting on a flat piece of glass. A sheet of filter paper was placed over the top to prevent particles from falling in while the solvent evaporated. After approximately 4 hours, the film was removed from the glass plate, sandwiched between metal rings, and placed in a vacuum oven at 50°C for at least 16 hours. The film was removed from the glass and placed between the metal rings to insure even drying under vacuum. The films were then subjected to tests to measure their diffraction efficiencies. Table 1 below demonstrates the amount of polycarbonate and solvent needed to generate specific film thicknesses set forth in the examples.

**Table 1**

| Film thickness | wt of PC | ml of CH₂Cl₂ |
|---|---|---|
| 55-65um | ∼0.175g | 2ml |
| 110-125um | ∼0.350g | 4ml |
| ∼250um | ∼0.700 | 6ml |

### EXAMPLE 1

This example was based upon a polycarbonate doped with 4-dimethylamino-2',4'-dinitrostilbene. The chemical representation of this dye is set forth below:

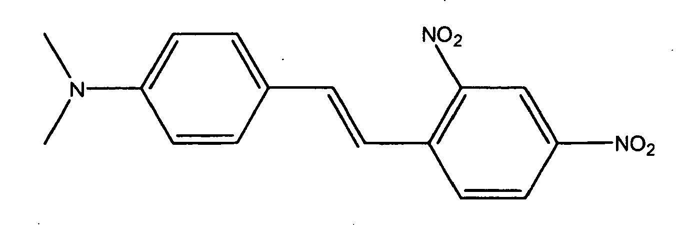

Several films were prepared by adding 4-dimethylamino-2',4'- dinitrostilbene to a polycarbonate substrate (commercially available as Lexan® from General Electric

Company) following the procedure outline above. The resulting films had varying concentrations of 4-dimethylamino-2',4'- dinitrostilbene and varying thicknesses, as set forth below in Table'2. Films were exposed to light at a wavelength of 532 nm using a Coherent, Inc. DPSS 532 laser in order to write data to the media. A diffraction efficiency measurement was obtained using a set-up similar to that set forth in Figure 2: The table below shows the results achieved using the diffraction efficiency measurements.

**Table 2**

| Sample | Conc. (wt.%) | Thickness (µm) | Diffraction Measurement Results |
|---|---|---|---|
| 1 | 1 | 55 | Absorption at write wavelength too high - no measurement |
| 2 | 0.23 | 58 | Successful diffraction observed - signal too small to quantify |
| 3 | 0.17 | 58 | Successful diffraction observed - signal too small to quantify |
| 4 | 0.286 | 58 | Successful diffraction observed - signal too small to quantify |

### EXAMPLE 2

Based upon the results of the Example 1, a second series of samples were prepared utilizing a different dye. The dye selected was designed to shift the absorption peak to shorter wavelengths lowering the net absorption observed at the write wavelength. This was done so that higher concentrations of dye could be used to get larger changes in net refractive index. To accomplish this blue shift, a cyano group was used in place of one of the nitro groups of 4-dimethylamino-2',4'- dinitrostilbene to form 4-dimethylamino-4'-cyano-2'-nitrostilbene, the structure of which is set forth below:

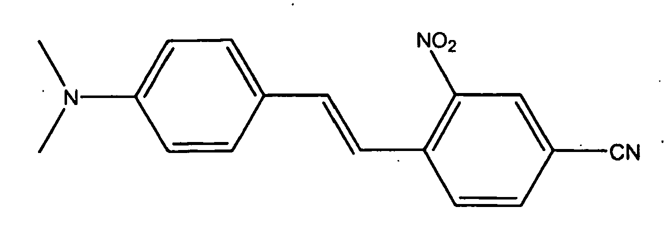

Several films were prepared by adding 4-dimethylamino-4'-cyano-2'-nitrostilbene to Lexan® following the procedure outlined above. The resulting films had varying concentrations of 4-dimethylamino-4'-cyano-2'-nitrostilbene and varying thicknesses, as set forth below in Table 3. These films were also exposed to light at a wavelength of 532 nm using a Coherent, Inc. 532 DPSS laser in order to write data to the media. Diffraction efficiency measurements were obtained using a set-up similar to that set forth in Figure 2. The table below shows the results achieved using the diffraction efficiency measurements.

**Table 3**

| Sample | Conc. (wt.%) | Thickness (µm) | Diffraction Measurement Results |
|---|---|---|---|
| 5 | 0.57 | 120 | ∼0.2-1% efficiency measured at 532 nm |
| 6 | 1.13 | 120 | ∼0.2% efficiency measured at 532 nm |
| 7 | 2.44 | 120 | 0.2-2% efficiency measured at 532 nm |
| 8 | 5.06 | 120 | ∼5% efficiency measured at 633 nm |

In addition to diffraction efficiency measurements, sample 8 was used to store an analog image. The digital holography setup depicted in Figure 1 was used to store an analog image into the 1.13 wt.% 4-dimethylamino-4'-cyano-2'-nitrostilbene sample (Sample 8). The image was written using a 532 nm laser. The image was then read using a 650 nm diode laser to produce the analog image. This material was successfully utilized in two-color holography (one color/wavelength for writing and another for reading).

### EXAMPLE 3

A set of sample films were prepared in an attempt to obtain improved concentrations of dye dissolved in polycarbonate. These samples utilized 4-hydroxy-2',4'-dinitrostilbene as the dye material, the structure of which is set forth below:

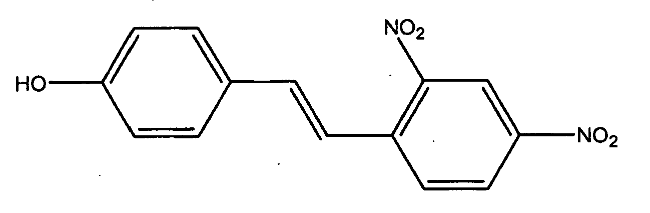

Several films were prepared by adding hydroxy dinitrostilbene to Lexan® following the procedures outlined above. The resulting films had varying concentrations of hydroxy dinitrostilbene as set forth below in Table 4. These films were also exposed to light at a wavelength of 532 nm using a Coherent, Inc. DPSS 532 laser in order to write data to the media. Diffraction efficiency measurements were obtained using a set-up similar to that set forth in Figure 2. The table below shows the results achieved using the diffraction efficiency measurements.

**Table 4**

| Sample | Conc. (wt.%) | Thickness (µm) | Diffraction Measurement Results |
|---|---|---|---|
| 9 | 1.05 | 120 | <0.1% efficiency measured at 633 nm |
| 10 | 4.02 | 120 | ∼0.14% efficiency measured at 633 nm |
| 11 | 9.82 | 120 | ∼4-8% efficiency measured at 532 nm |
| 12 | 20.6 | 120 | ∼5.3% efficiency measured at 532 nm |
| 13 | 14.6 | 120 | ∼10% efficiency measured at 532 nm |

### EXAMPLE 4

Sample discs were prepared via compression molding of bisphenol A polycarbonate doped with 3.3 wt.% and 6.6 wt.% respectively with the 4-hydroxy-2',4'-dinitrostilbene dye referred to above in Example 3. The samples were compressed in a mold under approximately 150 pounds of pressure at about 255°C. Following heating and compression for a time period sufficient to melt the mixture of polycarbonate and the dye, the mold was transferred to a cold press where it was held under 4000 pounds of pressure until the mold temperature decreased to about 50°C. The resulting discs were then removed from the mold and had diameters of about 1-inch and thicknesses of from about 1.5 mm to about 2 mm.

### EXAMPLE 5

Several experiments were performed to evaluate the performance of the discs prepared in Example 4 for angle-multiplexed holographic storage.

The absorption at 532 nm of 1.5-mm thick dye-doped polycarbonate samples produced in Example 4 was measured using the Coherent, Inc. DPSS 532 laser. The absorption values measured for these discs having dye concentrations of 3.3 wt.% and 6.6 wt.% were approximately 40% and 60%, respectively.

A 1.5 mm thick sample disc having 6.6 wt.% dye produced in accordance with Example 4 was placed in a plane-wave holographic characterization system as depicted in Figure 4. Angle multiplexing was obtained by rotating the sample. Holograms were recorded by 532 nm beams and holograms were read by 632 nm laser beam for kinetics measurements or by one of the two 532 nm laser beams for diffraction efficiency measurements.

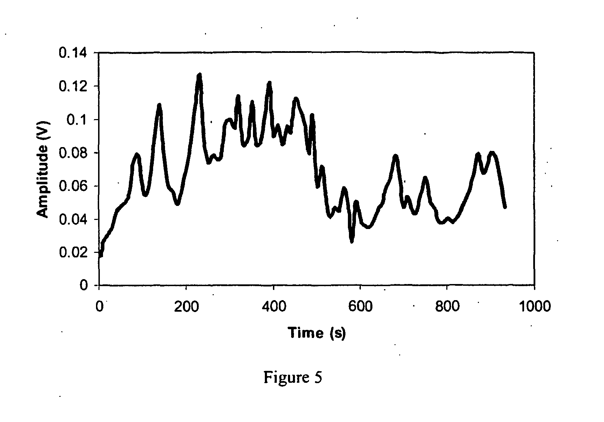

Kinetics measurements of hologram recordings were obtained using 100 mW of 532 nm light in each arm. Due to the low sensitivity, samples had to be exposed for hundreds of seconds. Results are shown in Figure 5. The oscillatory patterns shown in Figure 5 demonstrated low maximum diffraction efficiency values of a few percent. The oscillatory patterns had periods of tens of seconds.

The disc was then subjected to reading measurements using the 532 nm wavelength to determine M/#'s instead of trying to measure maximum diffraction efficiency. The reading exposures were much shorter than recording exposures; since each hologram could be written in a few tens of seconds, this limited the oscillatory problems.

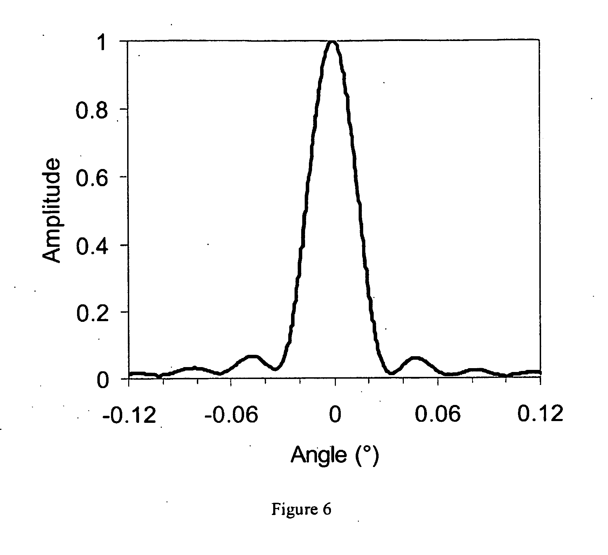

The angle selectivity at 0° was calculated to be approximately 0.04° which was confirmed by measurement using the experimental setup shown in figure 4, with the results set forth in Figure 6.

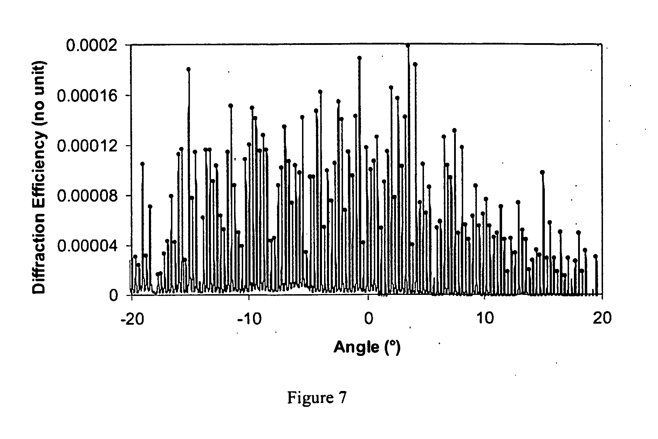

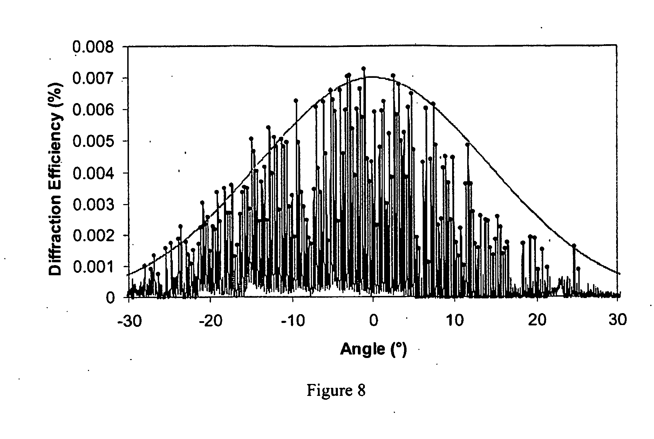

The experimental setup illustrated in Figure 4 was then used to angle-multiplex 130, and later 150, plane-wave holograms in the disc, which were separated by 0.3°. Graphs of the results are set forth in Figures 7 and 8.

Summing the square root of the diffraction efficiency of the holograms of Figure 7 gave a M/# of 1.1. By correcting the varying coefficient of reflection with angle (samples were not A/R coated), the M/# increased to 1.5.

It can be seen that the oscillatory phenomenon observed during kinetics measurements also affected the results shown in Figure 7 and Figure 8. Several pairs of adjacent holograms separated by only 0.3° had amplitudes that differed by a factor of 5.

Subsequently, 358 digital angle-multiplexed holograms were recorded in a 6.6% wt, 1.5-mm thick, dye-doped polycarbonate sample. 5 kbits were recorded per page. The measured raw Bit-Error-Rate was ∼5x10⁻³.

### EXAMPLE 6

Preparation of a bisphenol A (BPA) polycarbonate comprising 4-hydroxy-2',4'-dinitrostilbene as chain stopper: A 500 mL, 5-neck Morton flask equipped with a reflux condenser, pH probe, dip tube for phosgene, thermometer, and base addition tube was charged with BPA monomer (22.8 g, 100 mMol), 4-hydroxy-2',4'-dinitrostilbene (1.15 g, 4 mmol), triethylamine (150 µL, 1 mMol), 90 mL methylene chloride, and 90 mL water. After adjusting the pH to 10.5 with 25% aqueous sodium hydroxide solution, phosgene was introduced at a rate of 0.5 g/minute. Phosgene addition was continued until a 20% excess had been added (12g, 120 mMol) while maintaining the pH at 10.5 with the base solution. At the end of the reaction, the excess phosgene was sparged form the solution with a nitrogen stream. The brine layer was separated form the polymer-containing organic layer and discarded. The organic layer was diluted with additional methylene chloride, washed twice with IN HCl, washed three times with water, and precipitated into methanol to form 23 g of a bright yellow polymer. Gel permeation chromatography gave the following results: Mw 79,500, Mn 45,700 (based on polystyrene standards). NMR analysis confirmed the presence of the 4'-hydroxy-2,4-dinitrostilbene as chain stopper.

As can be seen from the above examples, the materials of the present disclosure had very simple geometry, low shrinkage, high optical quality (with proper processing), and were economical to produce.

While the disclosure has been illustrated and described in typical embodiments, it is not intended to be limited to the details shown, since various modifications and substitutions can be made without departing in any way from the spirit of the present disclosure. As such, further modifications and equivalents of the disclosure herein disclosed may occur to persons skilled in the art using no more than routine experimentation, and all such modifications and equivalents are believed to be within the spirit and scope of the disclosure as defined by the following claims.

## Claims

1. A holographic storage medium (60) comprising:
an optically transparent substrate;
a photochemically active narrowband dye material capable of undergoing a photo-induced change embedded in said optically transparent substrate; and
at least one photoproduct of said dye, said photoproduct being patterned within said substrate to provide at least one optically readable datum comprised within said holographic storage medium; wherein the photochemically active narrowband dye material comprises an organic dye having at least two aromatic rings joined by a bridging double bond and one of the at least two aromatic rings has at least one nitro group ortho to the bridging double bond;
wherein the optically transparent substrate is selected from the group consisting of polycarbonates, polyetherimides, polyvinyl chloride, polyolefins, polyesters, polyamides, polysulfones, polyimides, polyether sulfones, polyphenylene sulfides, polyether ketones, polyether ether ketones, ABS resins, polystyrenes, polybutadienes, polyacrylonitrile, polyacetals, polyphenylene ethers, ethylene-vinyl acetate copolymers, polyvinyl acetate, liquid crystal polymers, ethylene-tetrafluoroethylene copolymer, aromatic polyesters, polyvinyl fluoride, polyvinylidene fluoride, polyvinylidene chloride, and tetrafluoroethylenes.

2. The holographic storage medium of claim 1 wherein the photochemically active narrowband dye material comprises a substituted nitrostilbene selected from the group consisting of 4-dimethylamino-2',4'-dinitrostilbene, 4-dimethylamino-4'-cyano-2'-nitrostilbene, 4-hydroxy-2',4'-dinitrostilbene, and 4-methoxy-2',4'-dinitrostilbene.

3. A method for producing a holographic storage medium (60) comprising:
selecting an optically transparent substrate from the group consisting of polycarbonates, polyetherimides, polyvinyl chloride, polyolefins, polyesters,
polyamides, polysulfones, polyimides, polyether sulfones, polyphenylene sulfides, polyether ketones, polyether ether ketones, ABS resins, polystyrenes, polybutadienes, polyacrylonitrile, polyacetals, polyphenylene ethers, ethylene-vinyl acetate copolymers, polyvinyl acetate, liquid crystal polymers, ethylene-tetrafluoroethylene copolymer, aromatic polyesters, polyvinyl fluoride, polyvinylidene fluoride, polyvinylidene chloride, and tetrafluoroethylenes;
selecting a photochemically active narrowband dye material capable of undergoing a photo-induced change comprising an organic dye having at least two aromatic rings joined by a bridging double bond and one of the at least two aromatic rings has at least one nitro group ortho to the bridging double bond;
embedding said photochemically active narrowband dye material into said optically transparent substrate to afford a doped substrate; and
patterning a photoproduct of said dye within said doped substrate, at a wavelength capable of effecting said photo-induced change of said dye to form at least one holographic storage medium (60).

4. The method of claim 3, wherein the step of patterning a photoproduct of said dye within said doped substrate comprises writing data into said doped substrate with an information-carrying light pattern at a wavelength capable of effecting said photo-induced change of said dye.

5. A method for storing data in the holographic storage medium (60) of claim 1 comprising:
illuminating the storage medium with a signal beam possessing data and a reference beam simultaneously for storing a hologram of the data contained by the signal beam in the optical storage medium;
wherein the photochemically active narrowband dye material undergoes a photo-induced change upon exposure to the signal beam thereby forming a hologram in the storage media.

6. An method for optically reading the holographic storage medium (60) of claim 1 comprising:
illuminating the storage medium with a signal beam possessing data and a reference beam simultaneously for storing a hologram of the data contained by the signal beam in the optical storage medium, wherein the dye material undergoes an irreversible rearrangement upon exposure to the signal beam thereby forming a hologram in the storage media;
illuminating the holographic storage medium with a read beam having a wavelength shifted by 50 nm to 400 nm from the signal beam's wavelength; and reading the data contained by diffracted light from the hologram.

7. The method of claim 6 wherein the step of illuminating the storage medium with a signal beam comprises a signal beam having a wavelength of from 375 nm to 550 nm.

8. The method of claim 7 wherein the step of illuminating the storage medium with a read beam comprises a read beam having a wavelength of from 400 nm to 800 nm.

## Patentansprüche

1. Holographisches Speichermedium (60), aufweisend:
ein optisch transparentes Substrat;
ein photochemisch aktives schmalbandiges Farbstoffmaterial, das eingebettet in dem optisch transparenten Substrat fähig ist, eine lichtinduzierte Veränderung durchzumachen; und
wenigstens ein Photoprodukt des Farbstoffes, wobei das Photoprodukt in dem Substrat strukturiert ist, dass es wenigstens ein optisch lesbares Datenelement erzeugt, das in dem holographischen Speichermedium enthalten ist; wobei das photochemisch aktive schmalbandige Farbstoffmaterial einen organischen Farbstoff mit wenigstens zwei Aromatenringen aufweist, die durch eine brückenbildende Doppelbindung verbunden sind, und wobei einer von den wenigstens zwei Aromatenringen wenigstens eine Nitrogruppe ortho-ständig zu der brückenbildenden Doppelbindung hat;
wobei das optisch transparente Substrat aus der aus Polycarbonaten, Polyetherimiden, Polyvinylchlorid, Polyolefinen, Polyestern, Polyamiden, Polysulfonen, Polyimiden, Polyethersulfonen, Polyphenylensulfiden, Polyetherketonen, Polyetheretherketonen, ABS-Harzen, Polystyrolen, Polybutadienen, Polyacrylonitril, Polyacetalen, Polyphenylenethern, Ethylen-Vinylacetat-Copolymeren, Polyvinylacetat, Flüssigkristallpolymeren, Ethylen-Tetrafluorethylen-Copolymer, aromatischen Polyestern, Polyvinylfluorid, Polyvinylidenfluorid, Polyvinylidenchlorid und Tetrafluorethylenen bestehenden Gruppe ausgewählt ist.

2. Holographisches Speichermedium nach Anspruch 1, wobei das photochemisch aktive schmalbandige Farbstoffmaterial ein substituiertes Nitrostilben aufweist, das aus der aus 4-Dimethylamino-2',4'Dinitrostilben, 4-Dimethylamino-4'-Cyano-2'-Nitrostilben, 4-Hydroxy-2',4-Dinitrostilben und 4-Methoxy-2',4'-Dinitrostilben bestehenden Gruppe ausgewählt ist.

3. Verfahren zum Herstellen eines holographischen Speichermediums (60) mit den Schritten:
Auswählen eines optisch transparenten Substrates aus der aus Polycarbonaten, Polyetherimiden, Polyvinylchlorid, Polyolefinen, Polyestern, Polyamiden, Polysulfonen, Polyimiden, Polyethersulfonen, Polyphenylensulfiden, Polyetherketonen, Polyetheretherketonen, ABS-Harzen, Polystyrolen, Polybutadienen, Polyacrylonitril, Polyacetalen, Polyphenylenethern, Ethylen-Vinylacetat-Copolymeren, Polyvinylacetat, Flüssigkristallpolymeren, Ethylen-Tetrafluorethylen-Copolymer, aromatischen Polyestern, Polyvinylfluorid, Polyvinylidenfluorid, Polyvinylidenchlorid und Tetrafluorethylenen bestehenden Gruppe;
Auswählen eines photochemisch aktiven schmalbandigen Farbstoffmaterials, das fähig ist, eine lichtinduzierte Veränderung durchzumachen, das einen organischen Farbstoff mit wenigstens zwei Aromatenringen aufweist, die durch eine brückenbildende Doppelbindung verbunden sind, und wobei einer von den wenigstens zwei Aromatenringen wenigstens eine Nitrogruppe ortho-ständig zu der brückenbildenden Doppelbindung hat;
Einbetten des photochemisch aktiven schmalbandigen Farbstoffmaterials in das optisch transparente Substrat, um ein dotiertes Substrat zu erzeugen; und
Strukturieren eines Photoproduktes des Farbstoffes in dem dotierten Substrat bei einer Wellenlänge, die die photoinduzierte Änderung des Farbstoffes bewirken kann, um wenigstens ein optisch lesbares holographisches Speichermedium zu erzeugen.

4. Verfahren nach Anspruch 3, wobei der Schritt der Strukturierung eines Photoproduktes des Farbstoffes in dem dotierten Substrat das Schreiben von Daten in das dotierte Substrat mit einem informationstragenden Lichtmuster bei einer Wellenlänge beinhaltet, die die lichtinduzierte Änderung des Farbstoffes bewirken kann.

5. Verfahren zum Speichern von Daten in dem holographischen Speichermedium (60) nach Anspruch 1, mit den Schritten:
gleichzeitiges Bestrahlen des Speichermediums mit einem Daten besitzenden Signalstrahl und einem Bezugsstrahl, um ein Hologramm der in dem Signalstrahl enthaltenen Daten in dem optischen Speichermedium zu speichern;
wobei das photochemisch aktive schmalbandige Farbstoffmaterial eine lichtinduzierte Änderung nach der Aussetzung an den Signalstrahl durchmacht und **dadurch** ein Hologramm in dem Speichermedium erzeugt.

6. Verfahren zum optischen Lesen des holographischen Speichermediums (60) nach Anspruch 1, mit den Schritten:
gleichzeitiges Bestrahlen des Speichermediums mit einem Daten besitzenden Signalstrahl und einem Bezugsstrahl zum Speichern eines Hologramms der in dem Signalstrahl enthaltenen Daten in dem optischen Speichermedium, wobei das Farbstoffmaterial eine irreversible Neuanordnung nach der Aussetzung an den Signalstrahl durchmacht und **dadurch** ein Hologramm in dem Speichermedium erzeugt;
Bestrahlen des holographischen Speichermediums mit einem Lesestrahl mit einer um 50 mm bis 400 mm gegenüber der Wellenlänge des Signalstrahls verschobenen Wellenlänge; und Lesen der in gebrochenem Licht aus dem Hologramm enthaltenen Daten.

7. Verfahren nach Anspruch 6, wobei der Schritt der Bestrahlung des Speichermediums mit einem Signalstrahl einen Signalstrahl mit einer Wellenlänge von 375 mm bis 550 mm aufweist.

8. Verfahren nach Anspruch 7, wobei der Schritt der Bestrahlung des Speichermediums mit einem Lesestrahl mit einer Wellenlänge von 400 mm bis 800 mm aufweist.

## Revendications

1. Support de stockage holographique (60) comprenant:
un substrat optiquement transparent ;
un matériau colorant à bande étroite photochimiquement actif pouvant subir une modification photoinduite incrusté dans ledit substrat optiquement transparent ; et
au moins un produit photosensible dudit colorant, ledit produit photosensible étant enregistrée à l'intérieur dudit substrat afin de former au moins une donnée pouvant être lue de manière optique comprise à l'intérieur dudit support de stockage holographique ; dans lequel le matériau colorant à bande étroite photochimiquement actif comprend un colorant organique présentant au moins deux cycles aromatiques reliés par une double liaison de jonction et l'un des au moins deux cycles aromatiques comporte au moins un groupe nitro en position ortho sur la double liaison de jonction ;
dans lequel le substrat optiquement transparent est sélectionné à partir du groupe constitué par les polycarbonates , les polyétherimides, le polychlorure de vinyle, les polyoléfines, les polyesters, les polyamides, les polysulfones, les polyimides, les polyéther sulfones, les sulfures de polyphénylène, les polyéther cétones, les polyéther-éther-cétones, les résines d'ABS, les polystyrènes, les polybutadiènes, le polyacrylonitrile, les polyacétales, les éthers de polyphénylène, les copolymères éthylène-acétate de vinyle, l'acétate polyvinyle, les polymères à cristaux liquides, le copolymère éthylène-tétrafluoroéthylène, les polyesters aromatiques, le fluorure de polyvinyle, le fluorure de polyvinylidène, le chlorure de polyvinylidène, et les tétrafluoroéthylènes.

2. Support de stockage holographique selon la revendication 1, dans lequel le matériau colorant à bande étroite photochimiquement actif comprend un nitrostilbène substitué sélectionné à partir du groupe constitué par le 4-diméthylamino-2',4'-dinitrostilbène, le 4-diméthylamino-4'-cyano-2'-dinitrostilbène, le 4-hydroxy-2',4'-dinitrostilbène, et le 4-méthoxy-2',4'-dinitrostilbène.

3. Procédé de production d'un support de stockage holographique (60) comprenant :
la sélection d'un substrat optiquement transparent à partir du groupe constitué par les polycarbonates , les polyétherimides, le polychlorure de vynile, les polyoléfines, les polyesters, les polyamides, les polysulfones, les polyimides, les polyéther sulfones, les sulfures de polyphénylène, les polyéther cétones, les polyéther-éther-cétones, les résines d'ABS, les polystyrènes, les polybutadiènes, le polyacrylonitrile, les polyacétales, les éthers de polyphénylène, les copolymères éthylène-acétate de vinyle, l'acétate polyvinyle, les polymères à cristaux liquides, le copolymère éthylène-tétrafluoroéthylène, les polyesters aromatiques, le fluorure de polyvinyle, le fluorure de polyvinylidène, le chlorure de polyvinylidène, et les tétrafluoroéthylènes ;
la sélection d'un matériau colorant à bande étroite photochimiquement actif capable de subir un changement induit par rayonnement lumineux comprenant un colorant organique présentant au moins deux cycles aromatiques reliés par une double liaison de jonction et l'un des au moins deux cycles aromatiques comporte au moins un groupe nitro en position ortho sur la double liaison de jonction ;
l'incrustation dudit matériau colorant à bande étroite photochimiquement actif dans ledit substrat optiquement transparent afin de former un substrat dopé ; et
l'enregistrement d'un produit photosensible dudit colorant à l'intérieur dudit substrat dopé, à une longueur d'onde capable d'effectuer ledit changement induit par rayonnement lumineux dudit colorant afin de former au moins un support de stockage holographique (60).

4. Procédé selon revendication 3, dans lequel l'étape d'enregistrement d'un produit photosensible dudit colorant à l'intérieur dudit substrat dopé comprend l'écriture de données dans ledit substrat dopé avec un modèle lumineux porteur d'information à une longueur d'onde capable d'effectuer ledit changement induit par rayonnement lumineux dudit colorant.

5. Procédé de stockage de données dans le support de stockage holographique (60) selon la revendication 1 comprenant :
l'exposition du support de stockage à un faisceau de signal possédant des données et à un faisceau de référence de manière simultanée afin de stocker un hologramme des données contenues par le faisceau de signal dans le support de stockage optique ;
dans lequel le matériau colorant à bande étroite photochimiquement actif subit un changement induit par rayonnement lumineux lors de l'exposition au faisceau de signal formant ainsi un hologramme sur les supports de stockage.

6. Procédé de lecture optique du support de stockage holographique (60) selon la revendication 1 comprenant :
l'exposition du support de stockage à un faisceau de signal possédant des données et à un faisceau de référence de manière simultanée afin de stocker un hologramme des données contenues par le faisceau de signal dans le support de stockage optique, dans lequel le matériau colorant subit un ré-agencement irréversible lors de l'exposition au faisceau de signal, formant ainsi un hologramme sur les supports de stockage ;
l'exposition du support de stockage holographique à un faisceau de lecture présentant une longueur d'onde décalée de 50 nm à 400 nm par rapport à la longueur d'onde du faisceau de signal ; et la lecture des données contenues dans la lumière diffractée à partir de l'hologramme.

7. Procédé selon la revendication 6, dans lequel l'étape d'exposition du support de stockage à un faisceau de signal comprend un faisceau de signal présentant une longueur d'onde de 375 nm à 550 nm.

8. Procédé selon la revendication 7, dans lequel l'étape d'exposition du support de stockage à un faisceau de lecture comprend un faisceau de lecture présentant une longueur d'onde de 400 nm à 800 nm.
